# EUROPEAN PATENT APPLICATION

(11) **EP 1 757 556 A2**
(43) Date of publication of application: **28.02.2007**
(21) Application number: 06017079.2
(22) Date of filing: 16.08.2006
(51) Int. Cl.: B81B 7/00

(54) **Packaging a semiconductor device**

(30) Priority: 22.08.2005 JP 2005240058
(71) Applicant: SONY CORPORATION, Tokyo (JP); Interuniversitair Microelektronica Centrum, 3001 Leuven (BE)
(72) Inventor: Nakayama, Hirokazu, Shinagawa-ku Tokyo (JP); Okubora, Akihiko, Shinagawa-ku Tokyo (JP); Oya, Yoichi, Shinagawa-ku Tokyo (JP); Miyazaki, Hirohito, Shinagawa-ku Tokyo (JP); Baert, Kris, Kapeldreef 75 3001 Leuven (BE); De Wolf, Ingrid, Kapeldreef 75 3001 Leuven (BE); De Moor, Piet, Kapeldreef 75 3001 Leuven (BE); Beyne, Eric, Kapeldreef 75 3001 Leuven (BE)
(74) Representative: Müller - Hoffmann & Partner

(57) **Abstract**

To provide a semiconductor device configured that a micro device having a device substrate, a function element provided on the device substrate and having an oscillator or a movable part, first lands provided on a surface of the device substrate by being arranged on its outer circumference portion of the function element, and bumps provided to the first lands is mounted on the circuit board having second lands formed to correspond to the bumps, from the bump formation surface side, so that the bumps and the second lands are electrically connected; on which a sealing resin layer is formed to go round the outer circumference portion of the function element to fix connection portions of the bumps and the second lands, and to seal a clearance between the device substrate and the circuit board; and a cavity portion is formed between the function element and the circuit board.

## Description

### CROSS REFERENCES TO RELATED APPLICATIONS

The present invention contains subject matter related to Japanese Patent Application JP 2005-240058 filed in the Japanese Patent Office on August 22, 2005, the entire contents of which being incorporated herein by reference.

### BACKGROUND OF THE INVENTION

### 1. Field of the Invention

The present invention relates to a semiconductor device and a method of producing the same, particularly relates to a semiconductor device having a functional element having an oscillator or a movable part on its function surface, such as a SAW (surface acoustic wave) element, an F-BAR (thin film bulk acoustic wave resonator) or a MEMS (micro electro mechanical system), etc. and a method of producing the same.

### 2. Description of the Related Art

In recent years, mobile devices as typified by cellular phones and personal computers have been developed to be compact, light, multifunctional and high-performance, and parts and substrates composing these devices have been also developed to be compact, thin, light and high-density packaged. Also, as to mounting of semiconductors and other devices, a method has been shifted from mounting by molding and ceramic packaging to mounting a bare chip of a device directly to a substrate and sealing the same by a so-called flip-flop mounting technique as the mounting area becomes more compact and a transmission signal becomes high at speed.

However, in the direct mounting method by flip-flop, for example, in the case of a micro device having an oscillator or a movable part on its function surface, such as a SAW (surface acoustic wave) element, an F-BAR (thin film bulk acoustic wave resonator), or a MEMS (micro electro mechanical system), the function surface is not able to be covered with a sealing material, etc. Thus, an airtightly sealed package structure by using a substrate of ceramic, metal or glass, etc. has been applied.

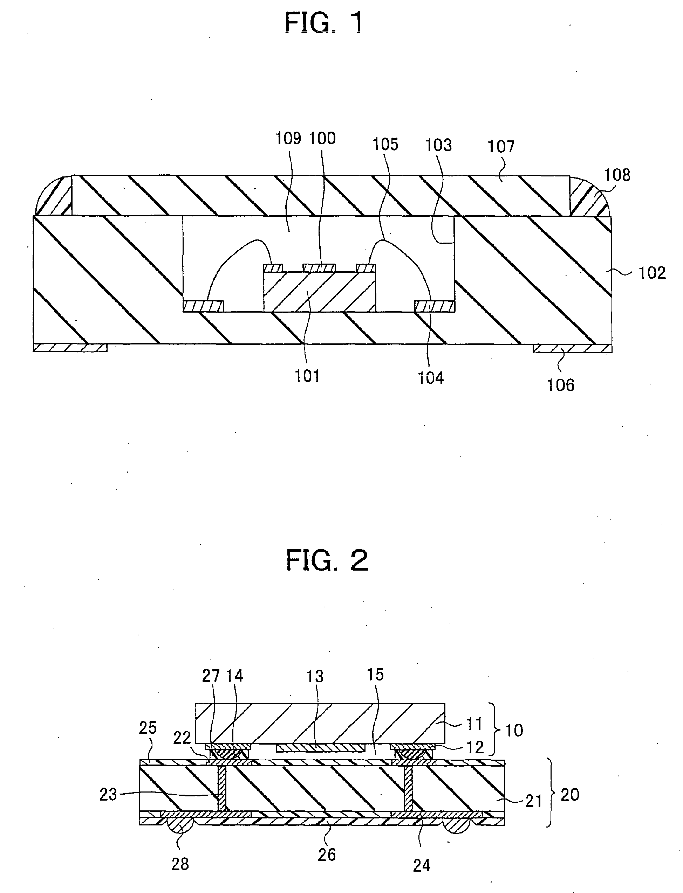

FIG. 1 is a sectional view of an example of a package structure of a SAW element, etc. of the related art.

For example, a semiconductor device 101 provided with a micro device 100 having an oscillator or a movable part on its function surface, such as a SAW element, is die-bonded to a bottom surface of a recessed portion 103 of a ceramic substrate 102 and connected to electrodes 104 provided in the recessed portion 103 by wire bonding 105. The electrodes 104 are connected to electrodes 106 provided on an external surface of the ceramic substrate 102.

The recessed portion 103 of the ceramic substrate 102 is covered with a cap 107 and sealed with a sealing material 108, and the recessed portion 103 and the cap 107 compose a airtightly sealed cavity portion 109, which is kept to be vacuum, decompressed, a reducing atmosphere or an inert gas atmosphere.

In a package having the configuration of the related art shown in FIG. 1, a substrate made by ceramic, metal or glass, etc. having a cavity structure is necessary for airtightly sealing the micro device, consequently, there is a disadvantage that a size and thickness of a module or a semiconductor device incorporating the micro device become large and thick particularly in a multi-chip module, wherein a plurality of devices are mounted on one substrate.

As one method to overcome the above disadvantage, Japanese Patent Publication No. 3514349 discloses a method of providing a connection bump and an insulation resin frame as an adhesion layer to a micro device, wherein the function surface is not able to be covered with a sealing material, such as a SAW element, and mounting the same with the face down on a substrate so as to provide a cavity portion between the substrate and the device and airtightly seal by the insulation resin frame. In this method, the device can be directly mounted on the substrate by flip-chip mounting in the same way as in other general devices, so that it is an effective method for making a module or a semiconductor device incorporating a micro device, such as a SAW element, compact and thin.

However, particularly in a micro device having a movable part, such as a MEMS, as a result of the affect of environment resistance concerning airtight property, atmosphere and electrostatic charging, etc. of the device, the electric characteristic, lifetime and other function characteristics are remarkably deteriorated. Therefore, it is preferable to finish the procedure up to the airtight sealing under a vacuum or reducing atmosphere when forming the device, and it is practically hard to apply the method disclosed in the above document to such a device.

Also, in the above document, the configuration of providing a connection bump and an insulation resin frame as an adhesion layer to a micro device, wherein the function surface is not able to be covered with a sealing material, such as a SAW element, is adopted. However, this configuration is necessary to provide a region for forming the connection bump and a region for forming the insulation resin frame as an adhesion layer on the micro device, so that the micro device itself is hard to be made compact.

### SUMMARY OF THE INVENTION

It is desirable to provide a semiconductor device formed by incorporating a micro device having a function element having an oscillator or a movable part on its function surface, such as a SAW element, F-BAR and MEMS, capable of airtightly sealing the function element and being made more compact and thinner, and a method of producing the same.

According to an embodiment of the present invention, there is provided a semiconductor device having: a micro device having a device substrate, a function element provided on a surface of the device substrate and having an oscillator or a movable part, first lands provided on the surface of the device substrate by being arranged on an outer circumference portion of the function element, and bumps provided to the first lands; a circuit board having second lands formed to correspond to the bumps thereon the micro device is mounted from the bump formation surface side so that the bumps and the second lands are electrically connected; and a sealing resin layer formed to go round the outer circumference portion of the function element to fix connection portions of the bumps and the second lands and to seal a clearance between the device substrate and the circuit board, wherein a cavity portion is formed between the function element and the circuit board.

The semiconductor device according to an embodiment of the present invention is obtained by mounting a micro device having a device substrate, a function element provided on a surface of the device substrate and having an oscillator or a movable part, first lands provided on the surface of the device substrate by being arranged on an outer circumference portion of the function element, and bumps provided to the first lands on a circuit board having second lands formed to correspond to the bumps from the bump formation surface side, so that the bumps and the second lands are electrically connected.

Here, a sealing resin layer is formed to go round the outer circumference portion of the function element to fix connection portions of the bumps and the second lands and to seal a clearance between the device substrate and the circuit board; and a cavity portion is formed between the function element and the circuit board.

According to an embodiment of the present invention, there is provided a semiconductor device having: a micro device having a device substrate, a function element provided on a surface of the device substrate and having an oscillator or a movable part, and first lands provided on the surface of the device substrate by being arranged on an outer circumference portion of the function element; a circuit board having second lands formed to correspond to the first lands and bumps provided to the second lands thereon the micro device is mounted from the first land formation surface side so that the bumps and the first lands are electrically connected; and a sealing resin layer formed to go round the outer circumference portion of the function element to fix connection portions of the bumps and the first lands and to seal a clearance between the device substrate and the circuit board, wherein a cavity portion is formed between the function element and the circuit board.

The semiconductor device according to an embodiment of the present invention is obtained by mounting a micro device having a device substrate, a function element provided on a surface of the device substrate and having an oscillator or a movable part, and first lands provided on the surface of the device substrate by being arranged on an outer circumference portion of the function element on a circuit board having second lands formed to correspond to the first lands and bumps provided to the second lands from the first land formation surface side so that the bumps and the first lands are electrically connected.

Here, a sealing resin layer is formed to go round the outer circumference portion of the function element to fix connection portions of the bumps and the first lands and to seal a clearance between the device substrate and the circuit board; and a cavity portion is formed between the function element and the circuit board.

According to an embodiment of the present invention, there is provided a method of producing a semiconductor device including mounting a micro device having a device substrate, a function element provided to a surface of the device substrate and having an oscillator or a movable part, first lands provided to the surface of the device substrate by being arranged on an outer circumference portion of the function element, and bumps provided to the first lands to a circuit board having second lands formed to correspond to the bumps, the method having the steps of: forming an uncured sealing resin layer on the second lands so as to go round the outer circumference portion of the function element by including a second land formation region of the circuit board; mounting the micro device to the circuit board from bumps formation surface side so that the bumps penetrate the sealing resin layer to contact and electrically connect to the second lands and the sealing resin layer seals a clearance between the device substrate and the circuit board; and curing the sealing resin layer to fix connection portions of the bumps and the second lands.

A method of producing a semiconductor device according to an embodiment of the present invention is a method of mounting a micro device having a device substrate, a function element provided to a surface of the device substrate and having an oscillator or a movable part, first lands provided to the surface of the device substrate by being arranged on an outer circumference portion of the function element, and bumps provided to the first lands to a circuit board having second lands formed to correspond to the bumps.

First, an uncured sealing resin layer is formed on the second lands so as to go round the outer circumference portion of the function element by including a second land formation region of the circuit board.

Next, the micro device is mounted on the circuit board from the bump formation surface side, so that the bumps penetrate the sealing resin layer to contact and electrically connect to the second lands, and the sealing resin layer seals a clearance between the device substrate and the circuit board.

Next, an insulation resin layer is cured to fix connection portions of the bumps and the second lands.

According to an embodiment of the present invention, there is provided a method of producing a semiconductor device including mounting a micro device having a device substrate, a function element provided to a surface of the device substrate and having an oscillator or a movable part, and first lands provided to the surface of the device substrate by being arranged on an outer circumference portion of the function element to a circuit board having second lands formed to correspond to the first lands and bumps provided to the second lands, the method having the steps of: forming an uncured sealing resin layer on the first lands so as to go round the outer circumference portion of the function element by including a first land formation region of the device substrate; mounting the micro device to the circuit board from the first land formation surface side so that the bumps penetrate the sealing resin layer to contact and electrically connect to the first lands and the sealing resin layer seals a clearance between the device substrate and the circuit board; and curing the sealing resin layer to fix connection portions of the bumps and the first lands.

A method of producing a semiconductor device according to an embodiment of the present invention is a method of mounting a micro device having a device substrate, a function element provided to a surface of the device substrate and having an oscillator or a movable part, and first lands provided to the surface of the device substrate by being arranged on an outer circumference portion of the function element to a circuit board having second lands formed to correspond to the first lands and bumps provided to the second lands.

First, an uncured sealing resin layer is formed on the first lands so as to go round the outer circumference portion of the function element by including a first land formation region of the device substrate.

Next, the micro device is mounted to the circuit board from the first land formation surface side, so that the bumps penetrate the sealing resin layer to contact and electrically connect to the first lands, and the sealing resin layer seals a clearance between the device substrate and the circuit board.

Next, the sealing resin layer is cured to fix connection portions of the bumps and the second lands.

A semiconductor device according to an embodiment of the present invention which incorporates a micro device having a function element having an oscillator or a movable part on its function surface, such as a SAW element, F-BAR and MEMS, is capable of airtightly sealing the function element, and is prepared for becoming more compact and thinner.

A method of producing the semiconductor device according to an embodiment of the present invention is a method of producing by incorporating a micro device having a function element having an oscillator or a movable part on its function surface, such as a SAW element, F-BAR and MEMS, capable of airtightly sealing the function element and being prepared for producing a more compact and thinner semiconductor device.

### BRIEF DESCRIPTION OF THE DRAWINGS

The above and other features of embodiments of the present invention will be apparent in more detail with reference to the accompanying drawings, in which:
FIG. 1 is a schematic sectional view of a semiconductor device according to the related art;
FIG. 2 is a schematic sectional view of a semiconductor device (micro package) according to a first embodiment;
FIG. 3A and FIG. 3B are schematic sectional views of a configuration example of an F-BAR as one of function elements;
FIG. 4A is a schematic sectional view of a configuration example of a MEMS as one of function elements, and FIG. 4B is a schematic sectional view of a configuration example of an SAW element;
FIG. 5A is a plan view of a step of producing a semiconductor device according to the first embodiment, and FIG. 5B is a schematic sectional view thereof;
FIG. 6A is a plan view of a step of producing a semiconductor device according to the first embodiment, and FIG. 6B is a schematic sectional view thereof;
FIG. 7 is a schematic sectional view of a step of producing a semiconductor device according to the first embodiment;
FIG. 8A is a plan view of a step of producing a semiconductor device according to the first embodiment, and FIG. 8B is a schematic sectional view thereof;
FIG. 9A and FIG. 9B are schematic sectional views of steps of producing a semiconductor device according to the first embodiment;
FIG. 10 is a schematic sectional view of a semiconductor device (micro package) according to a second embodiment;
FIG. 11A is a plan view of a step of producing a semiconductor device according to the second embodiment, and FIG. 11B is a schematic sectional view thereof;
FIG. 12A is a plan view of a step of producing a semiconductor device according to the second embodiment, and FIG. 12B is a schematic sectional view thereof;
FIG. 13A and FIG. 13B are schematic sectional views of steps of producing a semiconductor device according to the second embodiment;
FIG. 14A and FIG. 14B are schematic sectional views of steps of producing a semiconductor device according to the second embodiment thereof;
FIG. 15A is a plan view of a step of producing a semiconductor device according to the second embodiment, and FIG. 15B is a schematic sectional view thereof;
FIG. 16 is a schematic sectional view of a step of producing a semiconductor device according to the second embodiment;
FIG. 17A is a plan view of a step of producing a semiconductor device according to the second embodiment, and FIG. 17B is a schematic sectional view thereof;
FIG. 18A and FIG. 18B are schematic sectional views of steps of producing a semiconductor device according to the second embodiment;
FIG. 19 is a schematic sectional view of a semiconductor device (micro package) according to a third embodiment;
FIG. 20 is a schematic sectional view of a step of producing a semiconductor device according to the third embodiment;
FIG. 21A to FIG. 21D are schematic: sectional views of a step of producing a semiconductor device according to the third embodiment;
FIG. 22A is a plan view of a step of producing a semiconductor device according to the third embodiment, and FIG. 22B is a schematic sectional view thereof;
FIG. 23 is a schematic sectional view of a step of producing a semiconductor device according to the third embodiment;
FIG. 24A is a plan view of a step of producing a semiconductor device according to the third embodiment, and FIG. 24B is a schematic sectional view thereof;
FIG. 25A and FIG. 25B are schematic sectional views of a step of producing a semiconductor device according to the third embodiment;
FIG. 26 is a schematic sectional view of a semiconductor device according to a fourth embodiment;
FIG. 27A and FIG. 27B are schematic sectional views of steps of producing a semiconductor device according to the fourth embodiment; and
FIG. 28A and FIG. 28B are schematic sectional views of steps of producing a semiconductor device according to the fourth embodiment.

### DESCRIPTION OF THE PREFERRED EMBODIMENTS

Below, a semiconductor device and a method of producing the same according to embodiments of the present invention will be explained with reference to attached drawings.

### First Embodiment

FIG. 2 is a schematic sectional view of a semiconductor device (micro package) according to the present embodiment.

For example, the semiconductor device is configured that a micro device 10 provided with a function element 13 having an oscillator or a movable part on its function surface, such as a SAW element, F-BAR and MEMS, is mounted on a circuit board 20 by facedown mounting.

The micro device 10 has, for example, a device substrate 11 made by silicon or glass, etc., a function element 13 having the above oscillator or movable part and provided on a surface of the device substrate 11, first lands 12 provided on the surface of the device substrate 11 by being arranged on an outer circumferential portion of the function element 13, and bumps 14 provided to the first lands 12.

The bumps 14 are projections formed on the first lands 12 of the micro device 10, for example, by a plating method, printing method and ball-bonding method, etc. and having conductivity, which serve as connection electrodes for electrical connection at the time of being mounted on a circuit board, etc.

The circuit board 20 has a base material 21, second lands 22 formed to correspond to the bumps 14 on one surface of the base material 21, wiring 24 formed on the other surface of the base material 21, internal wiring 23 for connecting second lands 22 and wiring 24, etc. by penetrating the base material 21, and a flattening resin layer 25 for flattening a formation surface of the second lands 22. A circuit board having a single layer configuration is shown in FIG. 2, but it may be a multilayer substrate.

The micro device 10 is mounted on the circuit board 20 from the bump 14 formation surface side, so that the bumps 14 and the second lands 22 are electrically connected.

A sealing resin layer 27 is formed to go round an outer circumference portion of the function element 13, so that connection portions of the bumps 14 and the second lands 22 are fixed, and a clearance between the device substrate 11 and the circuit board 20 are sealed.

Here, a cavity portion 15 is formed between the function element 13 and the circuit board 20, and the sealing resin layer 27 functions to airtightly seal inside the cavity portion 15 configured by inner wall surfaces of the device substrate 11, the function element 13, the circuit board 20 and the sealing resin layer 27. The cavity portion 15 is kept to be, for example, vacuum, decompressed, a reducing atmosphere or an inert gas atmosphere.

In the circuit board 20, the formation surface of the second lands 22 is flattened due to provision of the above flattening resin layer 25 to an extent that, for example, a level difference between the second lands 22 and a part excepting the second lands 22 becomes 10% or less of a film thickness of the sealing resin layer 27 on the second land 22 formation surface on the circuit board 20.

For example, it is flattened, so that the sealing resin layer 27 becomes 20 to 30 µm or so and the above level difference becomes 2 to 3 µm or less. As a result, it is possible to seal with high airtightness.

Also, on the other surface of the surface mounted with the micro device 10 of the circuit board 20 is formed a permanent resist layer 26, and solder ball bumps 28 for circuit board are formed on opening portions of the permanent resist layer 26 to serve as connection terminals for mounting to other mounting substrate.

The above function element 13 having an oscillator or a movable part on its function surface is, for example, a SAW element, F-BAR or MEMS, etc.

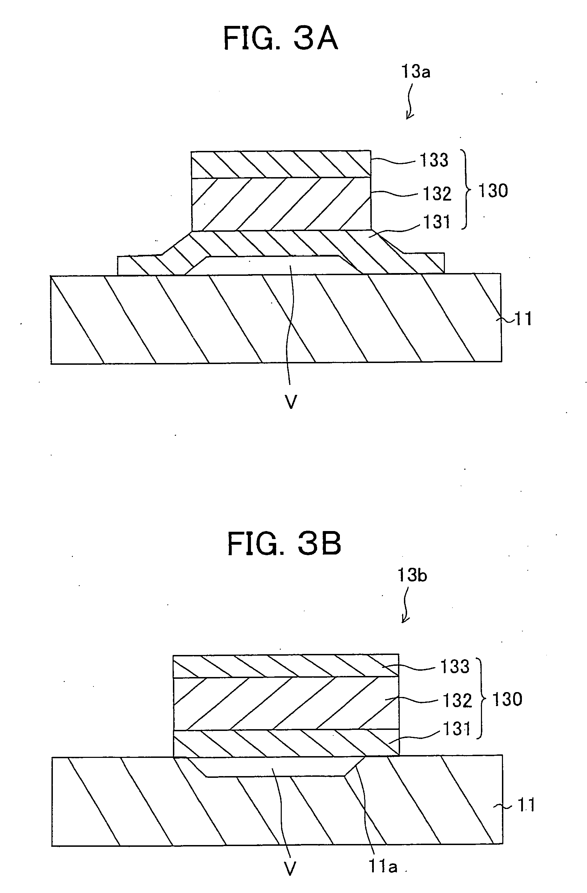

FIG. 3A is a schematic sectional view showing the configuration of an example of F-BAR as one of function elements.

For example, the device substrate 11 is formed with an elastic resonant film 130 made by a stacked body of a lower electrode 131, a piezoelectric film 132 and an upper electrode 133 via a clearance V forming a predetermined resonant region. The F-BAR 13a is configured as such.

The lower electrode 131 and the upper electrode 133 are made of a conductive material, such as Al, Pt, Au, Cu, W, Mo and Ti, and formed to be a film thickness of, for example, 0.1 to 0.5 µm.

Also, the piezoelectric film 132 is made of a piezoelectric material, such as aluminum nitride and zinc oxide, which is a fine film highly oriented to the c-axis, provided with an excellent piezoelectric characteristic and elastic characteristic, and formed to be a film thickness of, for example, 1.5 µm or less.

The clearance V is supported by legs formed to be a bent shape at end portions of the lower electrode 131, and a height of the clearance V is, for example, a several µm or so.

A film thickness each of the lower electrode 131, the upper electrode 133, and the piezoelectric film 132, a height of the clearance V, etc. can be suitably adjusted in accordance with the resonant frequency.

Here, since there arises difference in acoustic impedance on the boundary surface of the clearance V and the elastic resonant film 130, resonance of the elastic resonant film 130 is reflected to the elastic resonant film 130 side without being transmitted to the device substrate 11 and, particularly in the case of satisfying a standing wave condition within the elastic resonant film, it becomes a resonant state. Namely, an acoustic wave generated by vertical vibration of the thickness of the elastic resonant film 130 is effectively blocked inside the elastic resonant film 130, so that a loss of vibration energy can be reduced and a compact piezoelectric resonator can be realized.

FIG. 3B is a schematic sectional view of the configuration of another example of an F-BAR as one of function elements.

For example, a recessed portion 11a to be the clearance V composing a predetermined resonant region is formed on the device substrate 11, and the elastic resonant film 130 made by a multilayer body of the lower electrode 131, the piezoelectric film 132 and the upper electrode 133 is formed at both end portions of the recessed portion 11a to hold the clearance V. An F-BAR 13b is configured as such.

The lower electrode 131, the piezoelectric film 132 and the upper electrode 133 may be the same material and same film thickness as those of the above F-BAR 13a.

Depth of the recessed portion 11a to be the clearance V is, for example, several µm or so, and film thicknesses of the lower electrode 131, the upper electrode 133 and the piezoelectric film 132 and the height of the clearance V, etc. can be suitably adjusted in accordance with the resonant frequency.

Here, in the same way as the above F-BAR 13a, there arises a difference in acoustic impedance on the boundary surface of the clearance V and the elastic resonant film 130, so that vibration of the elastic resonant film 130 is reflected to the elastic resonant film 130 side without being transmitted to the device substrate 11 and, particularly in the case of satisfying a standing wave condition inside the elastic resonant film, it becomes a resonant state, and a piezoelectric resonance can be realized.

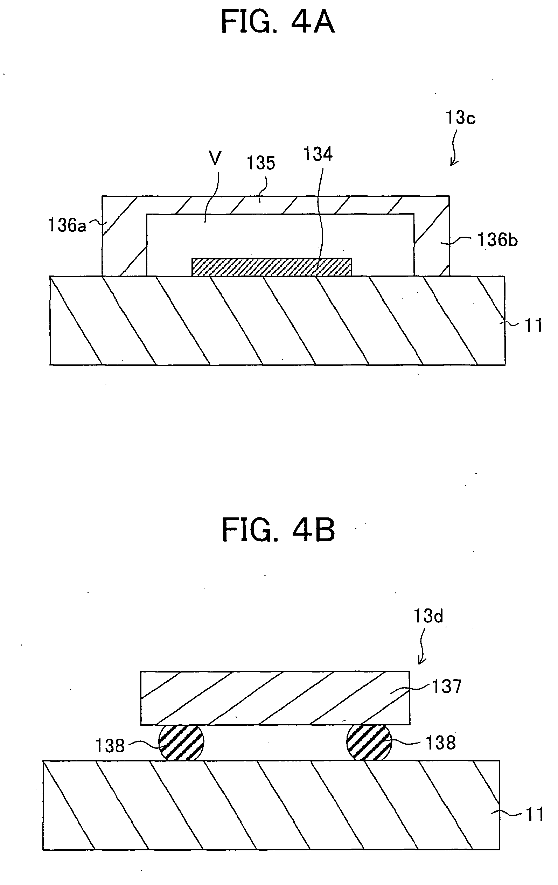

FIG. 4A is a schematic sectional view of the configuration of an example of an MEMS as one of function elements.

The MEMS 13c is composed of a device substrate 11; an electrode 134 formed on an operation region as an MEMS of the device substrate 11; an elastic film 135 formed to be away from the electrode 134 by a predetermined distance over the electrode 134, so that supporting portions (136a and 136b) provided at both ends contact the operation region; and the clearance V between the electrode 134 and the elastic film 135.

In the MEMS, a resonance, etc. is configured by mechanical vibration of the elastic film 135. Also, a transmitting/receiving switch and an antenna switch, etc. other than a resonance can be configured.

FIG. 4B is a schematic sectional view of the configuration of an example of an SAW element as one of function elements.

The SAW element 13d is configured as a result that a piezoelectric substrate 137 is mounted by a flip-flop method on the device substrate 11 via the bumps 138.

The surface of the piezoelectric substrate 137 is a part, to which an elastic surface wave is transmitted, held in the air so as not to contact other parts.

A semiconductor device according to the above present embodiment is configured by incorporating a micro device having a function element having an oscillator or a movable part on its function surface, such as an SAW element, F-BAR and MEMS, and is a semiconductor device capable of airtightly sealing the function element by being provided with a sealing resin layer while securing a distance between the device substrate 11 and the circuit board by bump connection and capable of being made compact and thinner.

Next, a method of producing the semiconductor device (micro package) according to the present embodiment will be explained with reference to drawings.

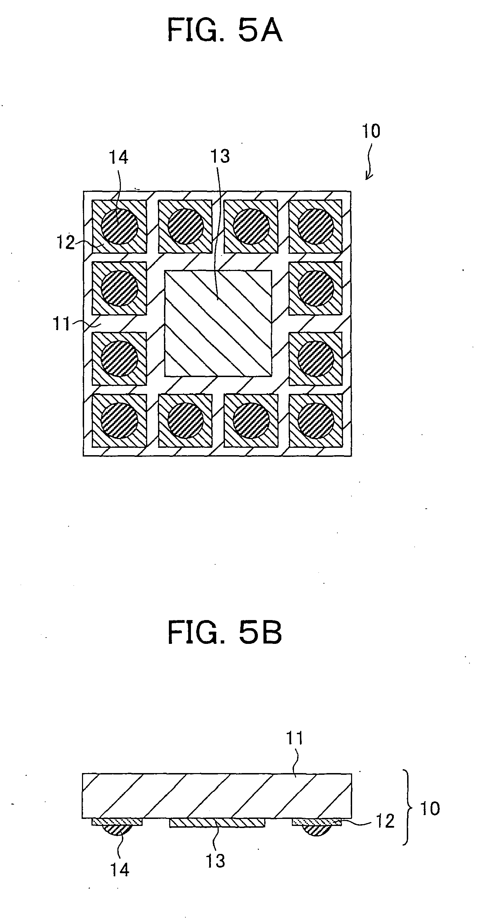

FIG. 5A is a plan view seeing from a bump formation surface of the micro device to be mounted on a circuit board, and FIG. 5B is a schematic sectional view thereof.

First, the micro device to be mounted is produced. The micro device 10 has, for example, a device substrate 11 made by silicon or glass, etc., a function element 13 having the above oscillator or movable part and provided on a surface of the device substrate 11, first lands 12 provided on the surface of the device substrate 11 by being arranged on an outer circumference portion of the function element 13, and bumps 14 provided to the first lands 12.

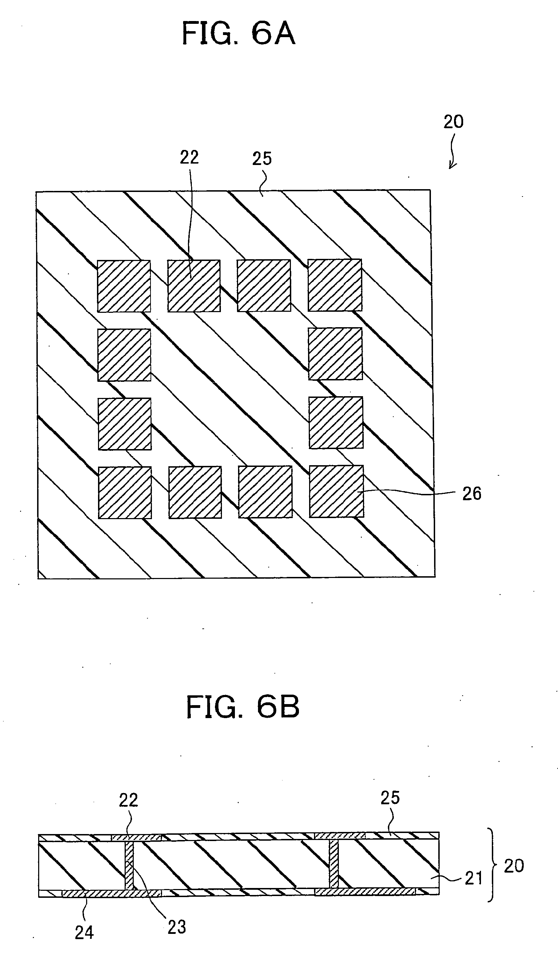

FIG. 6A is a plan view seen from a second land formation surface of a circuit board, on which the micro device is mounted, and FIG. 6B is a schematic sectional view thereof.

A circuit board 20 is configured to have a base material 21, second lands 22 formed on one surface of the base material 21 to correspond to the above bumps 14, wiring 24 formed on the other surface of the base material 21, internal wiring 23 for penetrating the base material 21 to connect the second lands 22 and the wiring 24, etc., and a flattening resin layer 25 for flattening a formation surface of the second lands 22.

A flattening resin layer for flattening a formation surface of the wiring 24 may be formed also on the other surface of the base material 21.

For example, to flatten by the flattening resin layer as explained above, after forming the second lands 22, wiring 24 and internal wiring 23 on the base material 21, a flattening resin 25 is applied to entire front and back surfaces of the substrate by a printing method, etc., then, after the resin is cured, a polishing step is performed mechanically, chemically, or by the both to polish the front and back surfaces of the substrate until the second lands 22 and wiring 24 are exposed.

As the above circuit board, it is preferable that a level difference in the thickness direction made by wiring and second lands on the front and back surfaces of the substrate is suppressed as much as possible. It may be also formed by a method of forming the circuit board by a so-called additive method or a method of transferring and burying the wiring and second lands on the base material, etc. other than the above method of polishing the flattening resin layer.

For example, by providing the flattening resin layer 25, the formation surface of the second lands 22 is preferably flattened so that a level difference between the second lands 22 and a part excepting the second lands 22 becomes 10% or less of a film thickness of the sealing resin layer 27 to be formed in a later step.

For example, it is flattened, so that the sealing resin layer 27 becomes 20 to 30 µm or so and the above level difference becomes 2 to 3 µm or less. As a result, it is possible to seal with heightened airtightness.

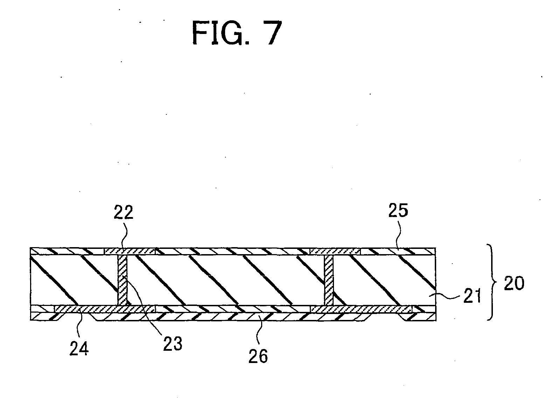

Next, as shown in a schematic sectional view in FIG. 7, a permanent resist layer 26 is formed except for portions for forming solder ball bumps for the circuit board on the circuit board 20 on its back surface of the second land formation surface to be mounted with the micro device 10.

This step includes a step of applying a permanent resist by a spin-coating method or a printing method, etc., a step of pattern formation of the permanent resist and a step of curing the permanent resist. Here, a general insulation resin can be used as the permanent resist and a so-called solder resist is particularly preferable. When using a photosensitive insulation resin is used as the permanent resist, it can be formed by performing pattern formation by performing exposure and developing processing by a lithography technique and curing the insulation resin. While when using a non-photosensitive insulation resin, it can be formed by curing the insulation resin, and performing dry etching processing, such as reactive ion etching and laser irradiation.

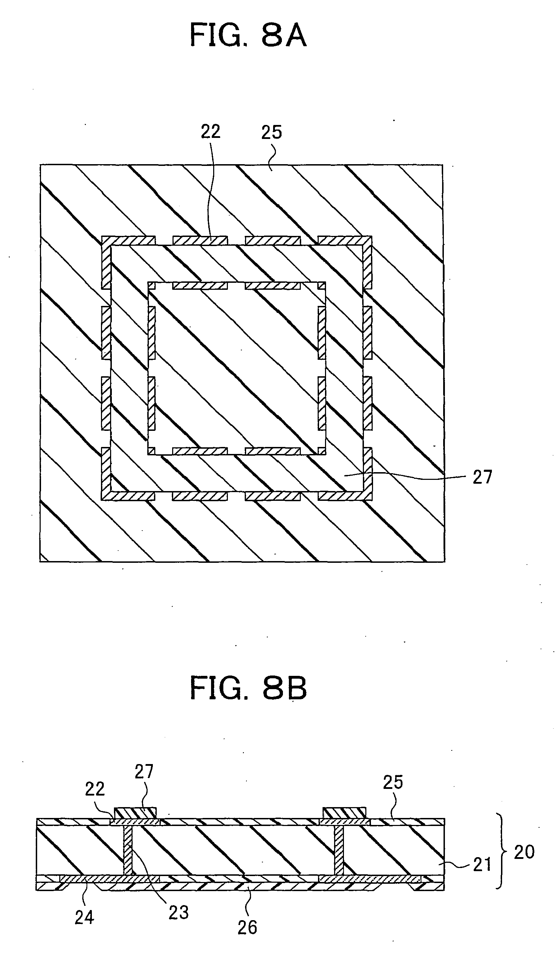

Next, as shown in the plan view seen from the second land formation surface of the circuit board in FIG. 8A and the schematic sectional view thereof in FIG. 8B, an uncured sealing resin layer 27 is formed on the second lands 22 so as to go round the outer circumference portion of the above function element 13 including the formation region of the second lands 22 on the circuit board 20.

This step includes, for example, a step of applying a photosensitive insulation resin by a spin-coating method or a printing method, etc., and a step of pattern formation of the photosensitive insulation resin by a lithography technique, etc.

Here, after a step of mounting the micro device as will be explained later on, the above photosensitive insulation resin forms a cavity portion between the micro device and the circuit board and airtightly seals the cavity portion to function as a sealing resin to block and protect from the outside. Therefore, a photosensitive insulation resin particularly having excellent airtightness and moisture resistance is preferable and, for example, a benzocyclobutene resin is preferable.

After applying the photosensitive insulation resin to the second land 22 formation surface on the circuit board 20, exposure and developing processing are performed for pattern formation. The formation region of the photosensitive insulation resin is formed to be a frame shape to entirely cover the second lands 22 formed on the circuit board 20. Note that since the surface for forming the sealing resin layer 27 on the circuit board 20 is subjected to flattening processing as explained above, unevenness on the surface is very small and preferable pattern forming accuracy can be easily attained.

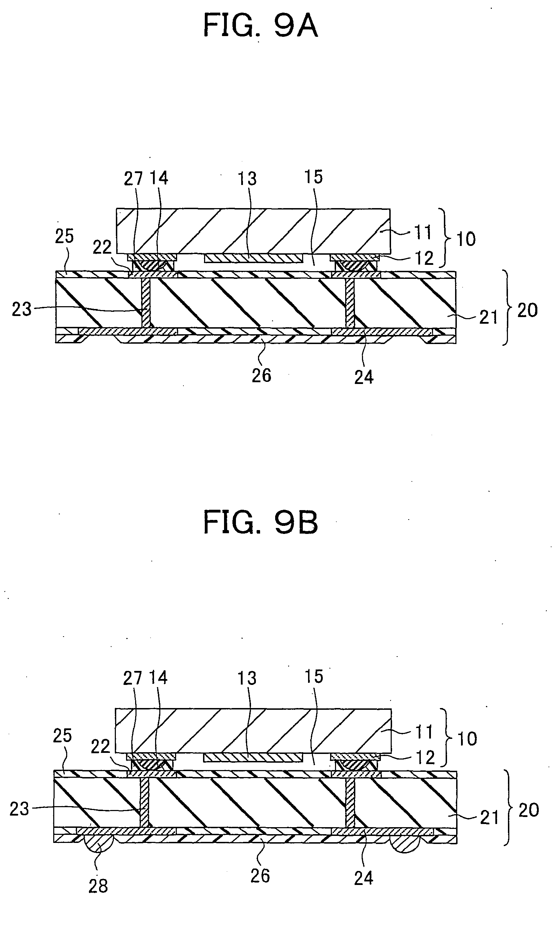

Next, as shown in the schematic sectional view in FIG. 9A, the micro device 10 is mounted on the circuit board 20 from the bump 14 formation surface side, so that the bumps 14 penetrate the sealing resin layer 27 to contact and electrically connect to the second lands 22 and the sealing resin layer 27 seals a clearance between the device substrate 11 and the circuit board 20, furthermore, the sealing resin layer 27 is cured to fix connection portions of the bumps 14 and the second lands 22.

This step includes, for example, a step of making the bump 14 formation surface of the micro device 10 and the sealing resin layer 27 formation surface of the circuit board 20 face to each other and aligning, a step of thermocompression by a heating and pressuring tool or ultrasonic bonding by using an ultrasonic horn, and a step of forming and sealing the cavity portion 15 between the micro device 10 and the circuit board 20 by curing the sealing resin layer 27, etc.

Here, the sealing resin layer 27 is formed as explained above on the second lands 22 on the circuit board 20, but since the sealing resin layer 27 is yet to be cured, the bumps 14 penetrate the sealing resin layer 27 when superimposing with the micro device 10, and the bumps 14 can contact the second lands 22. At this time, the both can be electrically connected by performing heating or ultrasonic processing. After that, by curing the sealing resin layer 27, the cavity portion 15 can be formed between the function element 13 of the micro device 10 and the circuit board 20.

Note that since the above steps can be performed in a state of being kept to be vacuum, decompressed, a reducing atmosphere or an inert gas atmosphere in a not shown chamber, inside of the cavity portion 15 configured by inner walls of the device substrate 11, the function element 13, the circuit board 20 and the sealing resin layer 27 can be also made to be vacuum, decompressed, a reducing atmosphere or an inert gas atmosphere, moreover, since the sealing resin layer 27 is formed by a photosensitive insulation resin having excellent airtightness and moisture resistance, the state can be easily maintained, as well.

Next, as shown in the schematic sectional view of FIG. 9B, on the circuit board 20 on the other surface of the mounting surface of the micro device 10, bumps 28 for the circuit board functioning as connection terminals for mounting to other mounting substrate are formed on an opening portion of the permanent layer 26.

Here, the bumps 28 for the circuit board can be formed by performing reflow processing by loading a soldering or other metal ball, but it is not limited to the method and it can be formed also by a method of forming by a printing method of a conductive paste or a soldering paste, a plating method, or a ball bonding method, etc.

From the above, a semiconductor device having the configuration shown in FIG. 2 can be produced.

According to the method of producing the semiconductor device according to the present embodiment, in a method of producing by incorporating a micro device having a function element having an oscillator or a movable part on its function surface, such as a SAW element, F-BAR and MEMS, it is possible to produce a semiconductor device capable of airtightly sealing the function element and being made compact and thinner.

### Second Embodiment

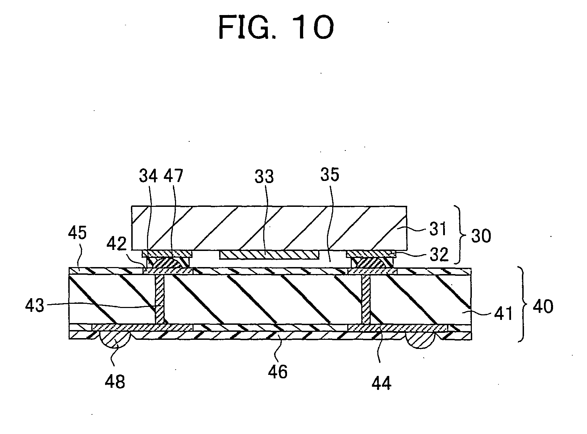

FIG. 10 is a schematic sectional view of a semiconductor device (micro package) according to the present embodiment.

In the same way as in the first embodiment, for example, it is configured that a micro device 30 provided with a function element 33 having an oscillator or a movable part on its function surface, such as a SAW element, F-BAR and MEMS, is mounted on a circuit board 40 by a facedown mounting method.

The micro device 30 has, for example, a device substrate 31 made by silicon or glass, etc., a function element 33 having the above oscillator or movable part and provided on a surface of the device substrate 31, and first lands 32 provided on the surface of the device substrate 31 by being arranged on the outer circumference portion of the function element 33.

The circuit board 40 has a base material 41, second lands 42 formed on one surface of the base material 41 and corresponding to first lands 32, bumps 47 provided to the second lands 42, wiring 44 formed on the other surface of the base material 41, internal wiring 43 for connecting the second lands 42 and the wiring 44, etc. by penetrating the base material 41, and a flattening resin layer 45 for flattening a second land 42 formation surface. A circuit board configured to be a single layer is shown in the figure, but it may be a multilayer substrate.

The micro device 30 is mounted on the circuit board 40 from the first land 32 formation surface side, so that the bumps 47 and the first lands 32 are electrically connected.

A sealing resin layer 34 is formed so as to go around an outer circumference portion of the function element 33, so that connection portions of the bumps 47 and the first lands 32 are fixed, and a clearance between the device substrate 31 and the circuit board 40 are sealed.

Here, a cavity portion 35 is formed between the function element 33 and the circuit board 40, and the sealing resin layer 34 functions to airtightly seal inside the cavity portion 35 configured by inner wall surfaces of the device substrate 31, the function element 33, the circuit board 40 and the sealing resin layer 34. The cavity portion 35 is kept to be, for example, vacuum, decompressed, a reducing atmosphere or an inert gas atmosphere.

Also, a permanent resist layer 46 is formed on the circuit board 40 on the other surface of the surface mounted with the micro device 30, and solder ball bumps 48 for a circuit board are formed on an opening portion of the permanent resist layer 46 to function as connection terminals for mounting to other mounting substrate.

The function element 33 having the above oscillator or movable part on its function surface is a SAW element, F-BAR or MEMS, etc. as shown in FIG. 3A, FIG. 3B, FIG. 4A, and FIG. 4B in the same way as in the first embodiment.

A semiconductor device according to the above present embodiment is configured by incorporating a micro device having a function element having an oscillator or a movable part on its function surface, such as a SAW element, F-BAR and MEMS, and is a semiconductor device capable of airtightly sealing the function element by being provided with a sealing resin layer and being made compact and thinner.

Next, as to a method of producing a semiconductor device (micro package) according to the present embodiment will be explained with reference to drawings.

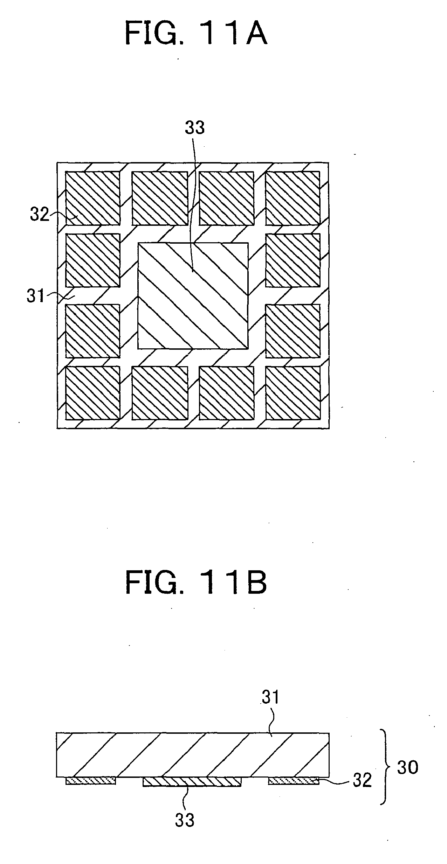

FIG. 11A is a plan view seen from a bump formation surface of the micro device to be mounted on the circuit board, and FIG. 11B is a schematic sectional view thereof.

First, the micro device to be mounted is produced. The micro device 30 is configured to have, for example, a device substrate 31 made by silicon or glass, a function element 33 having the above oscillator or movable part and provided on a surface of the device substrate 31, and first lands 32 provided on the surface of the device substrate 31 by being arranged on the outer circumference portion of the function element 33.

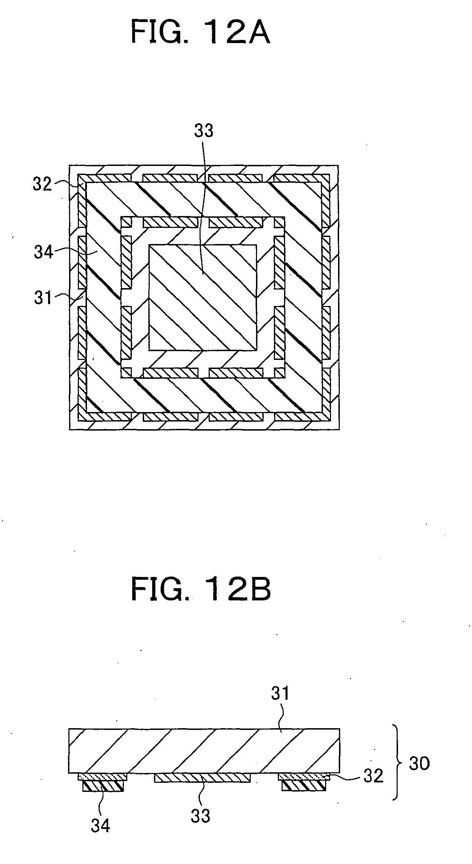

Next, as shown in the plan view seen from the first land formation surface of the micro device in FIG. 12A and the schematic sectional view thereof in FIG. 12B, an uncured sealing resin layer 34 is formed on the first lands 32 so as to go round the outer circumference portion of the function element 33 including the formation region of the first lands 32 on the device substrate 31.

This step includes, for example, a step of applying a photosensitive insulation resin by a spin-coating method or a printing method, etc., and a step of pattern formation of the photosensitive insulation resin by a lithography technique, etc.

Here, after a step of mounting the micro device as will be explained later on, the above photosensitive insulation resin forms a cavity portion between the micro device and the circuit board and functions as a sealing resin to airtightly seal the cavity portion and to block and protect from the outside. Therefore, a photosensitive insulation resin particularly having excellent airtightness and moisture resistance is preferable and, for example, a benzocyclobutene resin is preferable.

After applying the photosensitive insulation resin to the first land 32 formation surface on the device substrate 31, pattern formation is performed. The formation region of the photosensitive insulation resin is formed to be a frame shape to entirely cover the first lands 32 formed on the device substrate 31. Note that a film thickness of the first lands 32 is thin as several µm or so on the surface for forming the sealing resin layer 34 on the device substrate 31, and preferable pattern forming accuracy can be easily attained.

Note that when the function element 33 to be mounted with the micro device 30 is a MEMS, since the function element 33 has a movable part, it is difficult to apply an insulation resin on the function element 33.

In such a case, processing described below has to be performed in the production step of the micro device 30.

FIG. 13A is a sectional view of a step in the middle of producing a function element (MEMS) on the device substrate.

The function element is configured by an element portion 33a and a sacrifice layer 33b. The sacrifice layer 33b is a dummy layer provided for forming the element portion 33a and normally removed after forming the element, but in the present embodiment, it is left until formation of a sealing resin layer finishes and those not being removed the sacrifice layer 33b are used.

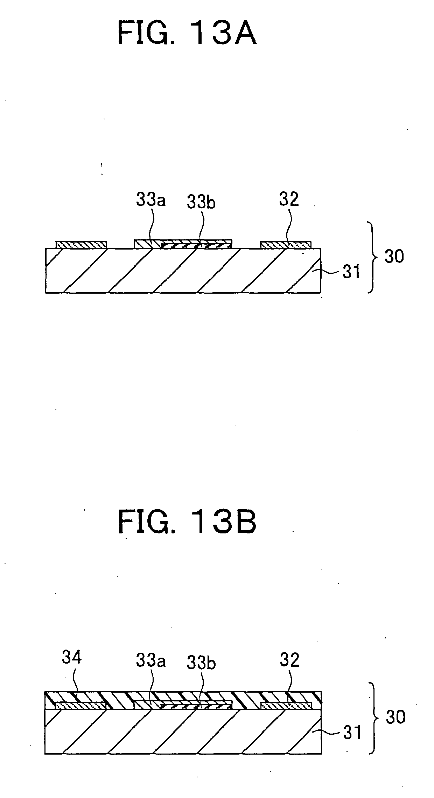

As shown in FIG. 13B, a sealing resin layer 34 is formed by applying a photosensitive insulation resin to an entire surface to cover the function element wherein the above sacrifice layer 33b is not removed by a spin-coating method or a printing method, etc.

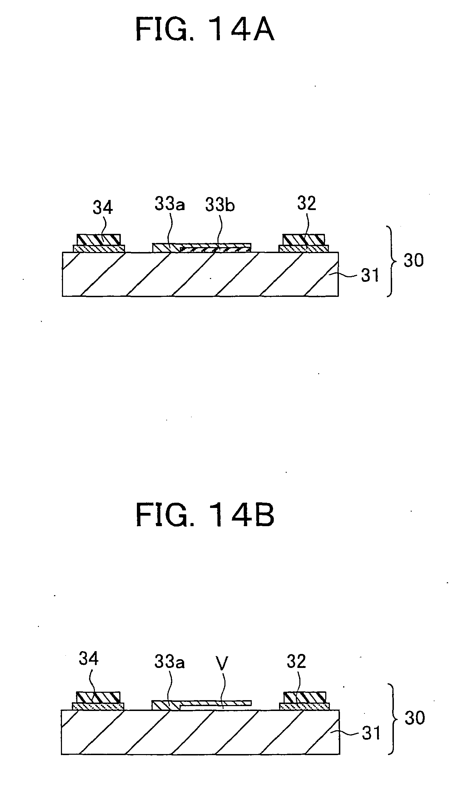

Next, as shown in FIG. 14A, by performing pattern processing on the photosensitive insulation resin by a lithography technique, the sealing resin layer 34 is removed so that the portion covering the first lands 32 is left so as to go round the outer circumference portion of the function element 33 including a first land 32 formation region on the device substrate 31.

Next, as shown in FIG. 14B, after the pattern formation of the sealing resin layer 34, the sacrifice layer 33b is removed by plasma processing of oxygen, etc. and a necessary clearance V is formed on the element portion 33a, so that a function element is completed.

As explained above, by leaving the sacrifice layer 33b in the processing of pattern formation of the sealing resin layer, the sealing resin layer 34 can be formed without damaging the element portion 33a.

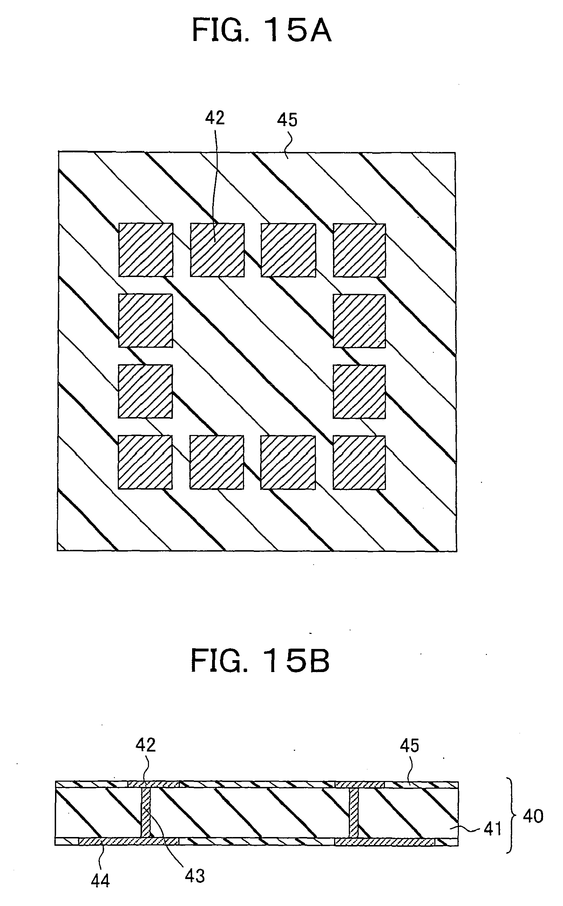

FIG. 15A is a plan view seen from a second land formation surface of the circuit board mounted with the micro device, and FIG. 15B is a schematic sectional view thereof.

The circuit board 40 is configured to have a base material 41, second lands 42 formed on one surface of the base material 41 to correspond to the first lands 32, wiring 44 formed on the other surface of the base material 41, internal wiring 43 for connecting the second lands 42 and the wiring 44, etc. by penetrating the base material 41, and a flattening resin layer 45 for flattening the second land formation surface.

Also, the flattening resin layer for flattening the wiring 44 formation surface may be also formed on the other surface of the base material 41.

For example, to flatten by the flattening resin layer as above, after forming the second lands 42, the wiring 44 and the internal wiring 43 on the base material 41, the flattening resin 45 is applied to entire front and back surfaces of the substrate by a printing method, etc., polishing processing is performed mechanically, chemically or by the both, and the front and back surfaces of the substrate are polished until the second lands 42 and the wiring 44 are exposed.

As the above circuit board, it is preferable that a level difference in the thickness direction made by the wiring and second lands on the front and back surfaces of the substrate is suppressed as much as possible, and it can be formed also by a method of forming the circuit board by a so-called additive method and a method of transferring and burying the wiring and second lands on the base material, etc. other than the method of polishing the flattening resin layer explained above.

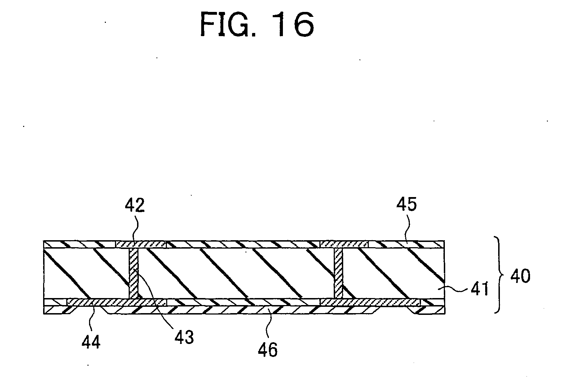

Next, as shown in the schematic sectional view in FIG. 16, a permanent resist layer 46 is formed on the circuit board 40 on the other surface of the second land formation surface to be mounted with the micro device 30 except for portions for forming solder ball bumps for circuit board.

This step includes a step of applying the permanent resist by a spin-coating method or a printing method, etc., a step of pattern formation of the permanent resist, and a step of curing the permanent resist. Here, a general insulation resin can be used as the permanent resist, and a so-called solder resist is particularly preferable. When using a photosensitive insulation resin as the permanent resist, it can be formed by performing pattern formation by performing exposure and developing processing by a lithography technique and curing the insulation resin, while when using a non-photosensitive insulation resin, it can be formed by curing the insulation resin and performing dry etching processing of reactive ion etching or laser irradiation.

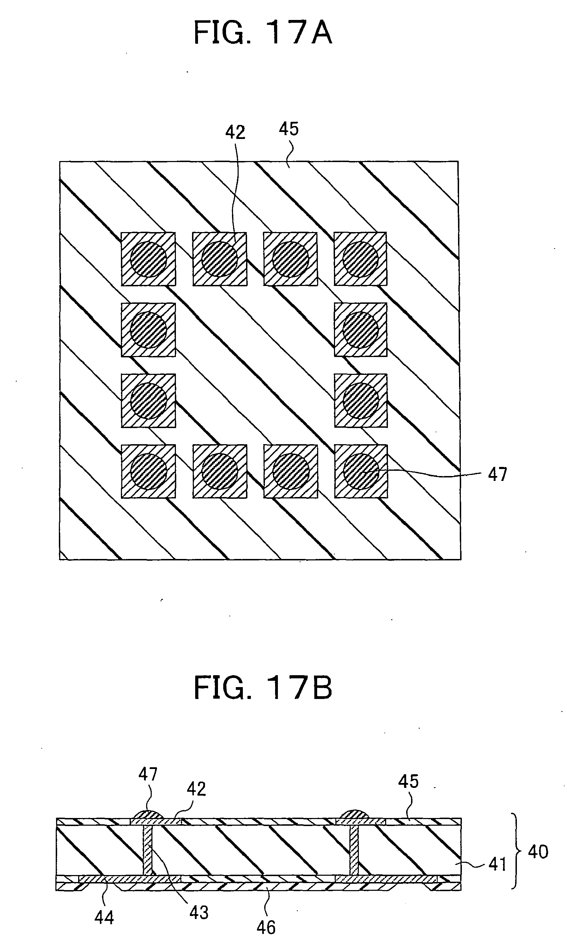

FIG. 17A is a plan view seen from the second land formation surface of the circuit board to be mounted with the micro device, and FIG. 17B is a schematic sectional view thereof.

Bumps 47 are formed on the second lands 42. This step is a step of forming projections having conductivity formed, for example, by a plating method, a printing method or a ball bonding method, etc. The bumps 47 function as connection electrodes for electrical connection when mounting the above micro device 30.

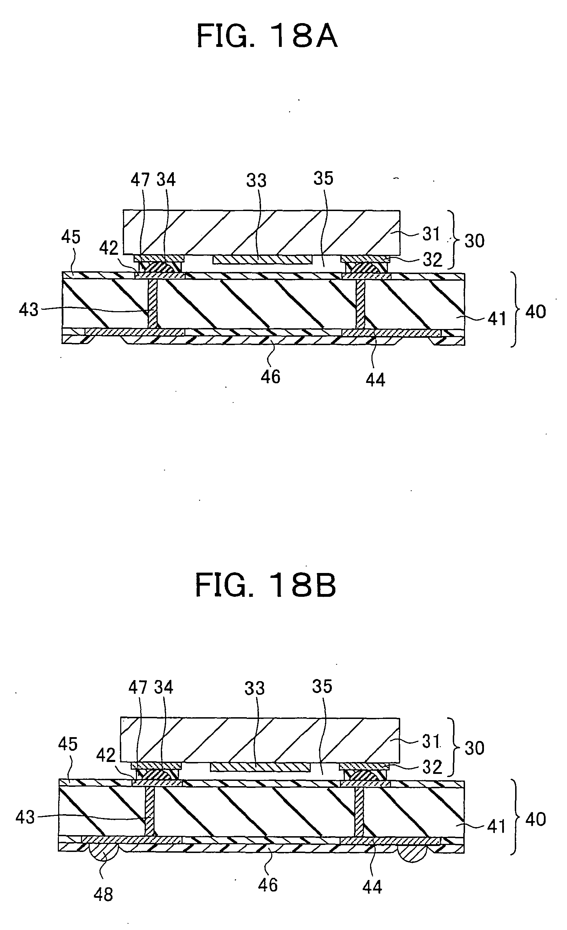

Next, as shown in the schematic sectional view in FIG. 18A, the micro device 30 is mounted on the circuit board 40 from the first land 32 formation surface side, so that the bumps 47 penetrate the sealing resin layer 34 to contact the first lands 32 to be electrically connected, and the sealing resin layer 34 seals the clearance between the device substrate 31 and the circuit board 40, furthermore, the sealing resin layer 34 is cured to fix connection portions of the bumps 47 and the first lands 32.

This step includes, for example, a step of making the sealing resin layer 34 formation surface of the micro device 30 and the bump 47 formation surface of the circuit board 40 face to each other and aligning, a step of thermocompression by a heating and pressuring tool or ultrasonic bonding by using an ultrasonic horn, and a step of forming and sealing the cavity portion 35 between the micro device 30 and the circuit board 40 by curing the sealing resin layer 34, etc.

Here, the sealing resin layer 34 is formed as explained above on the first lands 32 of the micro device 30, but since the sealing resin layer 34 is yet to be cured, the bumps 47 penetrate the sealing resin layer 34 when superimposing with the circuit board 40, and the bumps 47 can contact the first lands 32. At this time, the both can be electrically connected by performing heating or ultrasonic processing. After that, by curing the sealing resin layer 34, the cavity portion 35 can be formed between the function element 33 of the micro device 30 and the circuit board 40.

Note that since the above steps can be performed in a state of being kept to be vacuum, decompressed, a reducing atmosphere or an inert gas atmosphere in a not shown chamber, inside of the cavity portion 35 configured by inner walls of the device substrate 31, the function element 33, the circuit board 40 and the sealing resin layer 34 can be also made to be vacuum, decompressed, a reducing atmosphere or an inert gas atmosphere, moreover, since the sealing resin layer 34 is formed by a photosensitive insulation resin having excellent airtightness and moisture resistance, the state can be easily maintained, as well.

Next, as shown in the schematic sectional view of FIG. 18B, on the circuit board 40 on the other surface of the mounting surface of the micro device 30, solder ball bumps 48 for the circuit board functioning as connection terminals for mounting to other mounting substrate are formed on opening portions of the permanent resist layer 46.

Here, the solder ball bumps 48 for the circuit board can be formed by performing reflow processing by loading soldering or other metal balls, but it is not limited to the method and it can be formed also by a method of forming by a printing method of a conductive paste or a soldering paste, a plating method, or a ball bonding method, etc.

From the above, a semiconductor device having the configuration shown in FIG. 10 can be produced.

According to the method of producing the semiconductor device according to the above present embodiment, in a method of producing by incorporating a micro device having a function element having an oscillator or a movable part on its function surface, such as a SAW element, an F-BAR and a MEMS, it is possible to produce a semiconductor device capable of airtightly sealing the function element and being made compact and thinner.

### Third Embodiment

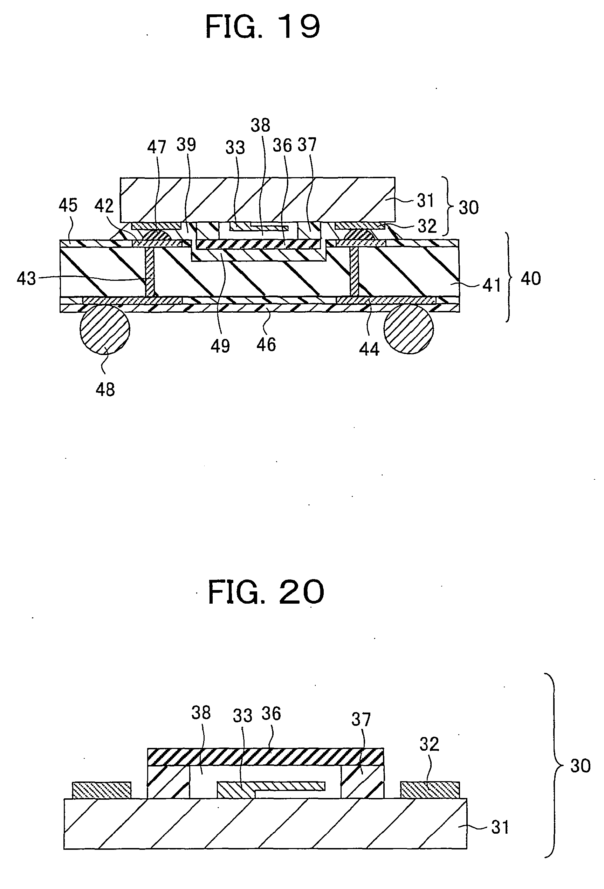

FIG. 19 is a schematic sectional view of a semiconductor device (micro package) according to the present embodiment.

A configuration is substantially the same as that in the second embodiment. When a function element 33 mounted in a micro device 30 is a MEMS and a sacrifice layer 33b of the function element 33 as shown in FIG. 13A in the second embodiment is already removed, it is preferable that the function element 33 is sealed in advance in a cavity portion formed by a cap 36 and a sealing resin 37, which is a structure according to the present embodiment. A circuit board 40 is formed with a recessed portion 49 corresponding to a cap 36 in advance, and the micro device 30 is mounted on the circuit board 40 so that the cap 36 is inserted to the recess portion 49. A sealing resin layer 39 is formed so as to go around an outer circumference portion of the cap 36 to protect the function element 33, so that connection portions of bumps 47 and first lands 32 are fixed to seal a clearance between the device substrate 31 and the circuit board 40 while burying a clearance between the cap 36 and the recessed portion 49.

FIG. 20 is a schematic sectional view showing a step of producing a semiconductor device according to the present embodiment, and illustrates a step of forming the micro device 30.

Namely, in the same way as in the second embodiment, the device substrate 31 is formed with the first lands 32 and the function element 33, removed with the sacrifice layer, and bonded with the cap 36 by a sealing resin 37 so as to protect the function element 33 to thereby form the cavity portion 38.

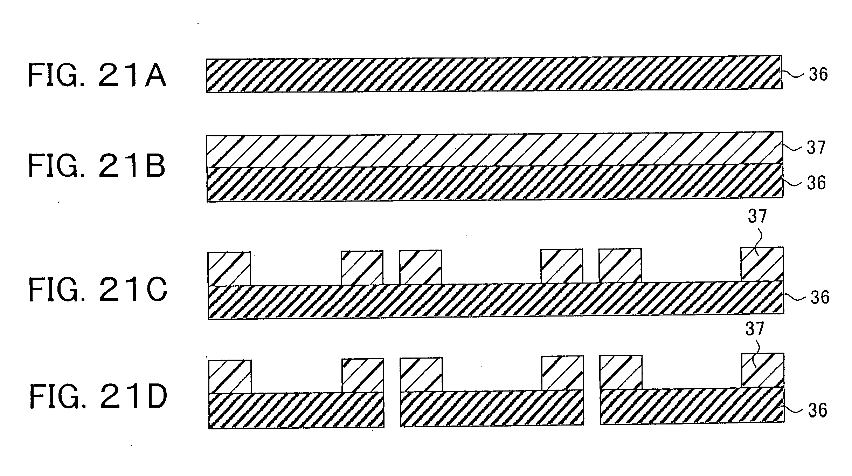

FIG. 21A to FIG. 21D are sectional views illustrating steps of forming a cap having the sealing resin.

First, to a wafer-shaped cap 36 shown in FIG. 21A capable of forming a plurality of caps, the sealing resin 37 is applied as shown in FIG. 21B by for example spin coating method with a thickness of 10 µm or so.

Then, as shown in FIG. 21C, the sealing resin 37 is subjected to a pattern processing, and as shown in FIG. 21D, a dicing processing is performed to divide the wafer shaped cap 36 into the respective pieces to thereby form the cap 36 having the insulative sealing resin 37. The cap 36 having the insulative sealing resin 37 obtained in the above way is bonded on the device substrate 31 so as to protect the function element 33.

For the above cap 36, for example glass, silicon layer, etc. may be used.

As the sealing resin 37, a photosensitive insulation resin particularly having excellent airtightness and moisture resistance is preferable used and, for example, a benzocyclobutene resin is preferable.

Since the sealing resin layer 37 formed on the cap 36 is yet to be cured, it is faced to and superposes with the micro device 30, and subjected to heating and pressing processing to be cured, as a result the cavity portion 38 can be formed between the function element 33 of the micro device 30 and the cap 36.

Note that since the above steps can be performed in a state of being kept to be vacuum, decompressed, a reducing atmosphere or an inert gas atmosphere in a not shown chamber, inside of the cavity portion 38 configured by inner walls of the micro device 30, the function element 33, the cap 36 and the sealing resin 37 can be also made to be vacuum, decompressed, a reducing atmosphere or an inert gas atmosphere, moreover, since the sealing resin 37 is formed by a photosensitive insulation resin having excellent airtightness and moisture resistance, the state can be easily maintained, as well.

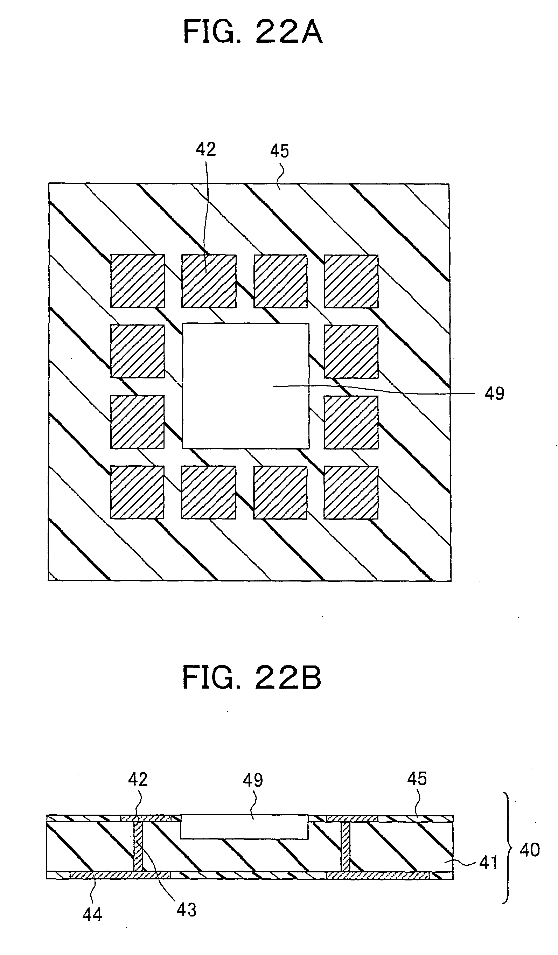

FIG. 22A is a plan view seeing from a second land formation surface of the micro device to be mounted on a circuit board, and FIG. 22B is a schematic sectional view thereof.

The circuit board 40 has a base material 41 formed in advance with the recessed portion 49 corresponding to the cap 36, second lands 22 formed to correspond to the first lands 32 on one surface of the base material 41, wiring 44 formed on the other surface of the base material 41, internal wiring 43 for connecting second lands 42 and wiring 44, etc. by penetrating the base material 41, and a flattening resin layer 45 for flattening a formation surface of the second lands 42.

A flattening resin layer for flattening a formation surface of the wiring 44 may be formed also on the other surface of the base material 41.

For example, to flatten by the flattening resin layer as explained above, after forming the second lands 42, wiring 44 and internal wiring 43 on the base material 41 formed with the recess portion 49 in advance, a flattening resin 45 is applied to entire front and back surfaces of the substrate by a printing method, etc., then, after the resin is cured, a polishing step is performed mechanically, chemically, or by the both to polish the front and back surfaces of the substrate until the second lands 42 and wiring 44 are exposed.

As the above circuit board, it is preferable that a level difference in the thickness direction made by wiring and second lands on the front and back surfaces of the substrate is suppressed as much as possible excepting a cavity portion. It may be also formed by a method of forming the circuit board by a so-called additive method or a method of transferring and burying the wiring and second lands on the base material, etc. other than the above method of polishing the flattening resin layer.

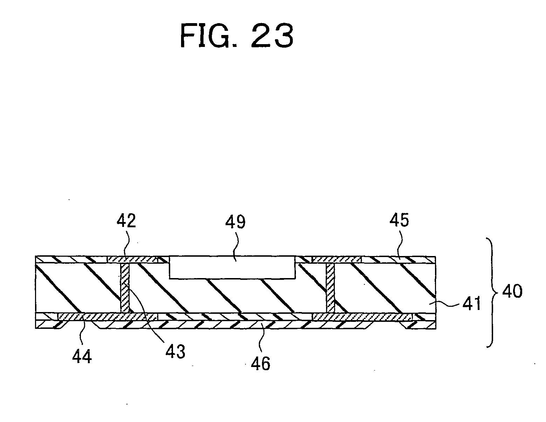

Next, as shown in a schematic sectional view in FIG. 23, a permanent resist layer 46 is formed except for portions for forming solder ball bumps for the circuit board on the circuit board 40 on its back surface of the second land formation surface to be mounted with the micro device 30 with the cap.

This step includes a step of applying a permanent resist by a spin-coating method or a printing method, etc., a step of pattern formation of the permanent resist and a step of curing the permanent resist. Here, a general insulation resin can be used as the permanent resist and a so-called solder resist is particularly preferable. When a photosensitive insulation resin is used as the permanent resist, it can be formed by performing pattern formation by performing exposure and developing processing by a lithography technique and curing the insulation resin. While when using a non-photosensitive insulation resin, it can be formed by performing dry etching processing, such as reactive ion etching and laser irradiation, after curing the insulation resin.

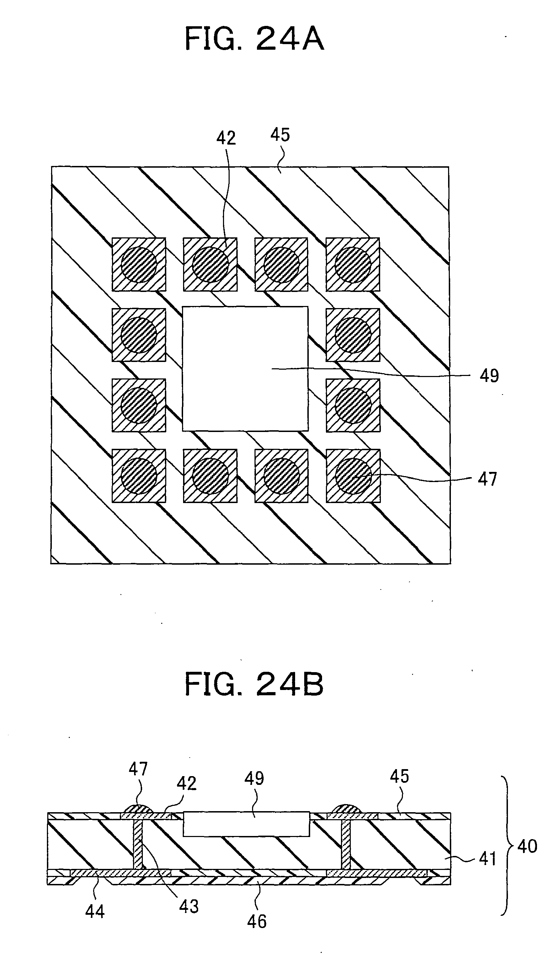

FIG. 24A is a plan view seen from the second land formation surface of the circuit board to be mounted with the micro device, and FIG. 24B is a schematic sectional view thereof.

Bumps 47 are formed on the second lands 42. This step is a step of forming projections having conductivity formed, for example, by a plating method, a printing method or a ball bonding method, etc. The bumps 47 function as connection electrodes for electrical connection when mounting the above micro device 30.

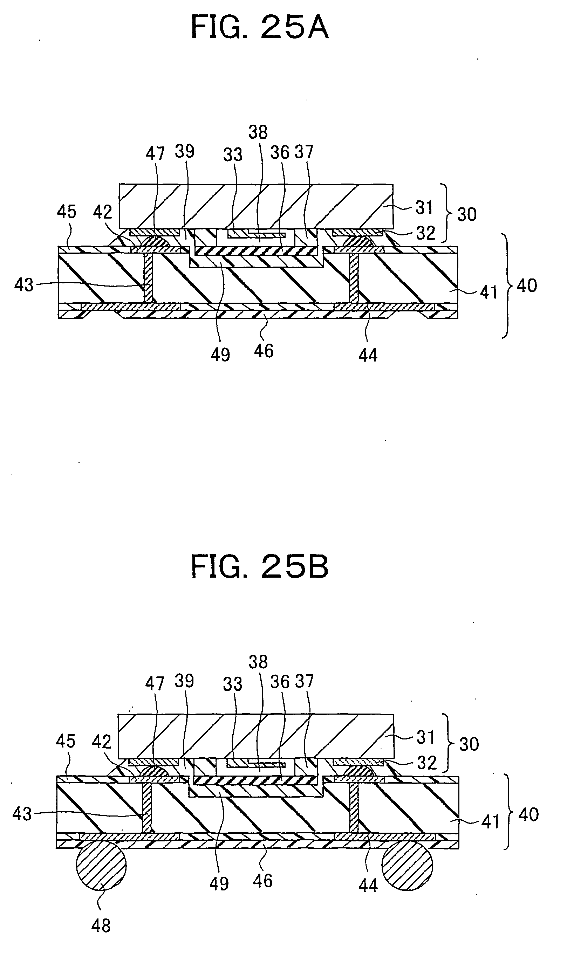

Next, as shown in the schematic sectional view in FIG. 25A, the micro device 30 is mounted on the circuit board 40 from the first land 32 formation surface side, so that the bumps 47 contacts the first lands 32 to be electrically connected, and the cap 36 is inserted to the recessed portion 49, furthermore, an underfill 39 is formed to fix connection portions of the bumps 47 and the first lands 32.

This step includes, for example, a step of making the cap 36 formation surface of the micro device 30 and the bump 47 of the circuit board 40 face to each other and aligning, a step of thermocompression by a heating and pressuring tool or ultrasonic bonding by using an ultrasonic horn, and a step of mounting the micro device 30 on the circuit board 40 by applying and curing the underfill 39. Here, the underfill 39 may be applied to the bumps 47 formation surface of the circuit board 40 in advance while superimposing with the circuit board 40, and mounted. And the recessed portion 49 formed in the circuit board 40 has functions not only of housing projections of the cap 36 of the micro device 30 and also of a stopper (dam) of the underfill 39, so, in view of a shape (thickness) of the cap 36 and the applying amount of the underfill, it is necessary to optimize the shape and depth of the recessed portion 49. Note that, this step can omit the mounting under vacuum, decompressed, a reducing atmosphere or an inert gas atmosphere, since the function element 33 of the micro device 30 is sealed by the cap in advance.

Next, as shown in the schematic sectional view of FIG. 25B, on the circuit board 40 on the other surface of the mounting surface of the micro device 30, solder ball bumps 48 for the circuit board functioning as connection terminals for mounting to other mounting substrate are formed on opening portions of the permanent resist layer 46.

Here, the solder ball bumps 48 for the circuit board can be formed by performing reflow processing by loading soldering or other metal balls, but it is not limited to the method and it can be formed also by a method of forming by a printing method of a conductive paste or a soldering paste, a plating method, or a ball bonding method, etc.

From the above, even when the function element 33 of the micro device 30 is a MEMS and the sacrifice layer 33b of the function element 33 is already removed, a semiconductor device shown in FIG. 19 can be produced and the semiconductor device the same as that having the configuration shown in FIG. 10 according to the second embodiment can be produced.

### Fourth Embodiment

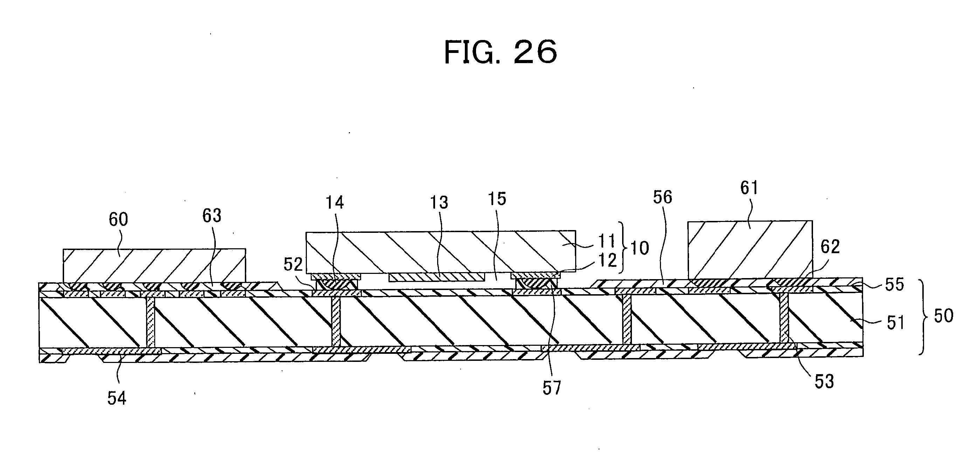

FIG. 26 is a schematic sectional view of a semiconductor device according to the present embodiment configured that a micro device 10 is mounted on a circuit board 50 by the facedown mounting method in the same way as in the above first embodiment and a bare IC 60 and a part 61 are mounted on the circuit board 50.

Bumps 14 formed on first lands 12 of the micro device 10 penetrate a sealing resin layer 57 formed on the circuit board 50 to be electrically connected to second lands 52 on the circuit board 50, and a cavity portion 15 is formed between the micro device 10 and the circuit board 50, so that the sealing resin layer 57 has a function of airtightly sealing inside the cavity portion. Other than the micro device 10, the bare IC 60 and the part 61 are mounted on the circuit board 50, but they are active/passive parts used by an IC for driving the micro device 10 or the peripheral circuit

Next, a method of producing a semiconductor device according to the present embodiment will be explained.

The micro device 10 used in the present embodiment is the same as that in the first embodiment.

Namely, the micro device 10 has, for example, a device substrate 11 made by silicon or glass, etc., a function element 13 having the above oscillator or movable part and provided on a surface of the device substrate 11, first lands 12 provided on the surface of the device substrate 11 by being arranged on an outer circumference portion of the function element 13, and bumps 14 provided to the first lands 12.

The bumps 14 are projections having conductivity formed on the first lands 12 of the micro device 10, for example, by a plating method, printing method or ball bonding method, etc. and function as connection electrodes for electrical connection when being mounted to the circuit board, etc.

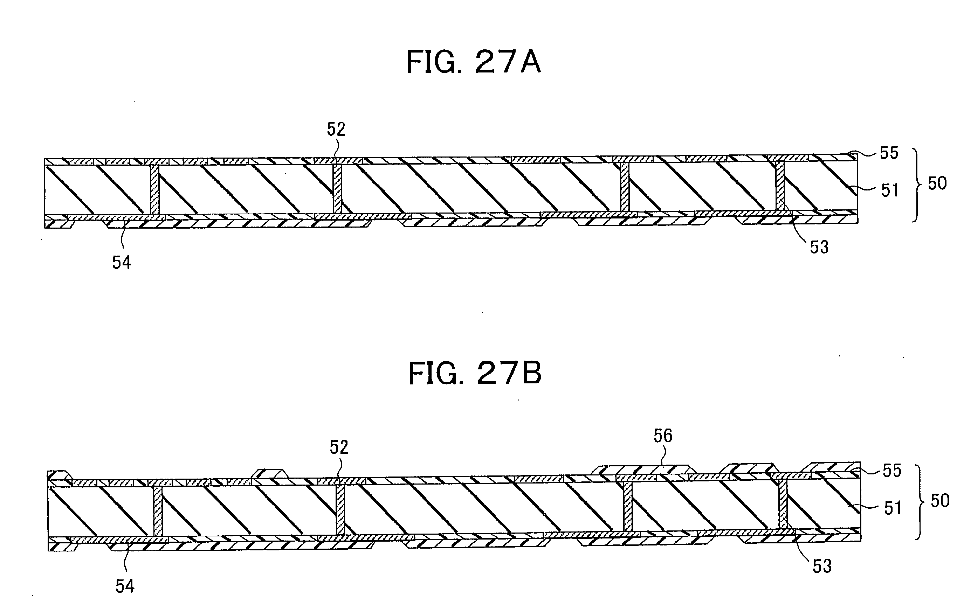

FIG. 27A is a schematic sectional view of a circuit board 50 according to the present embodiment. In FIG. 27A, an example of a both-sided substrate wherein the number of wiring layer is two is shown for simplification, but it may be a multilayer wiring substrate having multilayer wiring substrate.

As shown in FIG. 27A, the circuit board 50 has a base material 51, second lands 52, wiring 54, internal wiring 53 and a flattening resin 55.

For example, to flatten by the flattening resin layer as explained above, after forming the second lands 52, the wiring 54 and the internal wiring 53 on the base material 51, the flattening resin 55 is applied to entire front and back surfaces of the substrate by a printing method, etc. and cured, polishing processing is performed mechanically, chemically or by the both, and the front and back surfaces of the substrate are polished until the second lands 52 and the wiring 54 are exposed.

As the above circuit board, it is preferable that a level difference in the thickness direction made by the wiring and second lands on the front and back surfaces of the substrate is suppressed as much as possible, and it can be formed also by a method of forming the circuit board by a so-called additive method and a method of transferring and burying the wiring and second lands to the base material, etc. other than the method of polishing the flattening resin layer explained above.

Next, as shown in the schematic sectional view in FIG. 27B, a permanent resist layer 56 is formed to be a predetermined pattern on the circuit board 50 on the other surface of the second land formation surface to be mounted with the micro device 10 except for portions for forming circuit board bumps.

This step includes a step of applying the permanent resist by a spin-coating method or a printing method, etc., a step of pattern formation of the permanent resist, and a step of curing the permanent resist. Here, a general insulation resin can be used as the permanent resist, and a so-called solder resist is particularly preferable. When using a photosensitive insulation resin as the permanent resist, it can be formed by performing pattern formation by performing exposure and developing processing by a lithography technique and curing the insulation resin, while when using a non-photosensitive insulation resin, it can be formed by performing reactive ion etching, laser irradiation or other dry etching after curing the insulation resin.

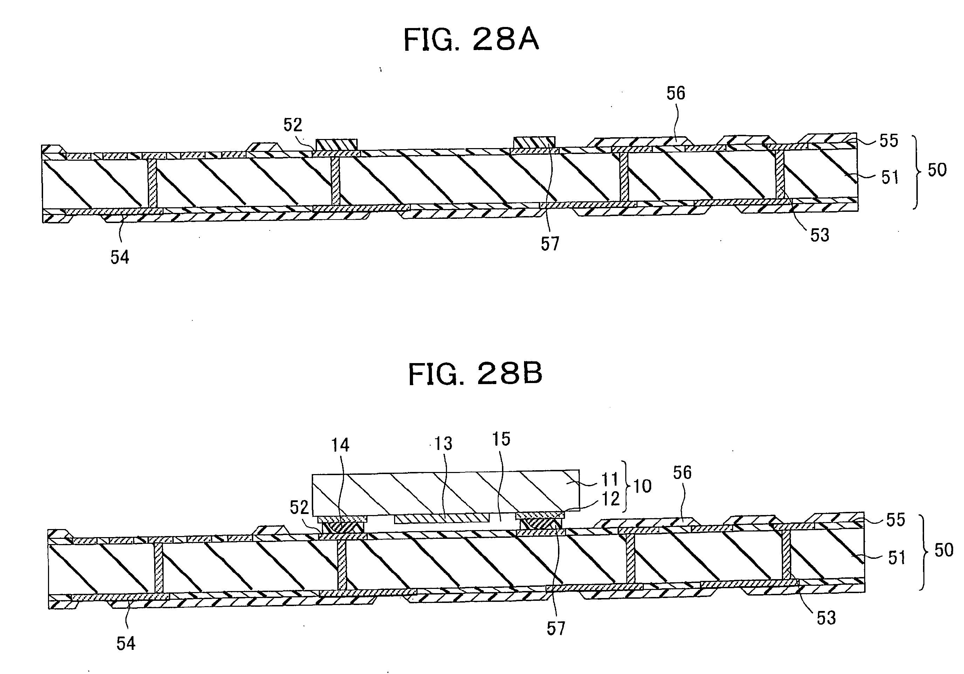

Next, as shown in the schematic sectional view in FIG. 28A, an uncured sealing resin layer 57 is formed on the second lands 52 of the circuit board 50 so as to go round the outer circumference portion of the function element including the formation region of the second lands 52 on the circuit board 50.

This step includes, for example, a step of applying a photosensitive insulation resin by a spin-coating method or a printing method, etc., and a step of pattern formation of the photosensitive insulation resin by a lithography technique, etc.

Here, after a step of mounting the micro device as will be explained later on, the above photosensitive insulation resin forms a cavity portion between the micro device and the circuit board and functions as a sealing resin to airtightly seal the cavity portion to block and protect from the outside. Therefore, a photosensitive insulation resin particularly having excellent airtightness and moisture resistance is preferable and, for example, a benzocyclobutene resin is preferable.

After applying the photosensitive insulation resin to the second land 52 formation surface on the circuit board 50, exposure and developing processing are performed for pattern formation. The formation region of the photosensitive insulation resin is formed to be a frame shape to entirely cover the second lands 52 formed on the circuit board 50.

Next, as shown in the schematic sectional view in FIG. 28B, the micro device 10 is mounted on the circuit board 50 from the bump 14 formation surface side, so that the bumps 14 penetrate the sealing resin layer 57 to contact the second lands 52, and the sealing resin layer 57 seals a clearance between the device substrate 11 and the circuit board 50, furthermore, the sealing resin layer 57 is cured to fix connection portions of the bumps 14 and the second lands 52.

This step includes, for example, a step of making the bump 14 formation surface of the micro device 10 and the sealing resin layer 57 formation surface of the circuit board 50 face to each other and aligning, a step of thermocompression by a heating and pressuring tool or ultrasonic bonding by using an ultrasonic horn, and a step of forming and sealing the cavity portion 15 between the micro device 10 and the circuit board 50 by curing the sealing resin layer 57, etc.

Here, the sealing resin layer 57 is formed as explained above on the second lands 52 on the circuit board 50, but since the sealing resin layer 57 is yet to be cured, the bumps 14 penetrate the sealing resin layer 57 when superimposing with the micro device 10, and the bumps 14 can contact the second lands 52. At this time, the both can be electrically connected by performing heating or ultrasonic processing. After that, by curing the sealing resin layer 57, the cavity portion 15 can be formed between the function element 13 of the micro device 10 and the circuit board 50.

Note that since the above steps can be performed in a state of being kept to be vacuum, decompressed, a reducing atmosphere or an inert gas atmosphere in a not shown chamber, inside of the cavity portion 15 configured by inner walls of the device substrate 11, the function element 13, the circuit board 50 and the sealing resin layer 57 can be also made to be vacuum, decompressed, a reducing atmosphere or an inert gas atmosphere, moreover, since the sealing resin layer 57 is formed by a photosensitive insulation resin having excellent airtightness and moisture resistance, the state can be easily maintained, as well.

Next, the circuit board 50 is mounted with a bare IC 60 and the part 61.

Here, the bare IC 60 and the part 61 are active/passive parts used by an IC for driving the micro device 10 or the peripheral circuit, and mounted on the circuit board 50 by using a bonding material 62, such as soldering and anisotropic conductive film, and an underfill material 63, etc. if necessary.

From the above, a semiconductor device having the configuration shown in FIG. 26 can be produced.

Note that in the present embodiment, a configuration example of forming bumps on the micro device side and forming a sealing resin layer on the circuit board side was explained, however, as shown in the second embodiment, the same semiconductor device as that of the present embodiment can be realized also when forming the sealing resin layer on the micro device side and forming bumps on the circuit board side.

According to the method of producing the semiconductor device according to the above present embodiment, in a method of producing by incorporating a micro device having a function element having an oscillator or a movable part on its function surface, such as a SAW element, an F-BAR and a MEMS, it is possible to produce a semiconductor device capable of airtightly sealing the function element and being made compact and thinner.

As explained in the above respective embodiments, by forming a sealing resin layer on second lands of the circuit board subjected to flattening processing, forming bumps on the device substrate of the micro device, and mounting on the circuit board by the facedown mounting method, the bumps formed on the device substrate of the micro device penetrate the sealing resin layer formed on the circuit board to attain electric connection; and by forming a cavity portion between the circuit board and the micro device and configuring to airtightly seal inside the cavity portion by the sealing resin layer formed on the circuit board, a conductive bump formation area for electrical connection and a sealing resin layer formation area for airtightly sealing the cavity portion can be approximately put together (identical), consequently, the semiconductor device (micro package) can be made compact.

Also, when mounting the micro device to the circuit board in a chamber kept to be vacuum, decompressed, in a reducing atmosphere or an inert gas atmosphere, inside the cavity portion formed between the micro device and the circuit board can be kept to be vacuum, decompressed, in a reducing atmosphere or an inert gas atmosphere. Also, by forming the sealing resin layer by a photosensitive insulation resin having excellent airtightness and moisture resistance, an atmosphere inside the cavity portion can be easily maintained and a package with high quality reliability can be provided.

The present invention is not limited to the above embodiments.

For example, a function element having an oscillator or a movable part is not limited to an SAW element, an F-BAR and a MEMS, and may be an element having other configuration as far as it has an oscillator or a movable part.

Other than that, a variety of modifications can be made within the scope of the present invention.

A semiconductor device according to an embodiment of the present invention can be applied to a semiconductor device having a semiconductor element having an oscillator or a movable part on its function surface, such as an SAW element, an F-BAR and a MEMS.

A method of producing the semiconductor device according to an embodiment of the present invention can be applied for producing a semiconductor device having a semiconductor element having an oscillator or a movable part on its function surface, such as an SAW element, F-BAR and MEMS.

It should be understood by those skilled in the art that various modifications, combinations, subcombinations and alterations may occur depending on design requirements and other factors in so far as they are within scope of the appeared claims or the equivalents thereof.

## Claims

1. A semiconductor device comprising:
a micro device having a device substrate, a function element provided on a surface of the device substrate and having an oscillator or a movable part, first lands provided on the surface of the device substrate by being arranged on an outer circumference portion of the function element, and bumps provided to the first lands;
a circuit board having second lands formed to correspond to the bumps thereon the micro device is mounted from the bump formation surface side so that the bumps and the second lands are electrically connected;
a sealing resin layer formed to go round the outer circumference portion of the function element to fix connection portions of the bumps and the second lands and to seal a clearance between the device substrate and the circuit board;
wherein a cavity portion is formed between the function element and the circuit board.

2. A semiconductor device as set forth in claim 1,
wherein the cavity portion configured by inner wall surfaces of the device substrate, the function element, the circuit board and the sealing resin layer is kept to be vacuum, decompressed, a reducing atmosphere or an

3. A semiconductor device as set forth in claim 1,
wherein a formation surface of the second lands of the circuit board is flattened.

4. A semiconductor device as set forth in claim 1,
wherein a level difference between the second lands and a part excepting the second lands is 10% or less of a film thickness of the sealing resin layer on the formation surface of the second lands of the circuit board.

5. A semiconductor device as set forth in claim 1,
wherein solder ball bumps for circuit board is formed on the other surface of the surface mounted with the micro device of the circuit board.

6. A semiconductor device as set forth in claim 1,
wherein
in the micro device, a cap is bonded on the device substrate to form the cavity portion to protect the function element, and
the sealing resin layer is formed to go round an outer circumference portion of the function element.

7. A semiconductor device as set forth in claim 6,
wherein
the circuit board is formed with a recessed portion corresponding to the cap, and
the micro device is mounted on the circuit board so that the cap is inserted to the recessed portion.

8. A semiconductor device comprising:
a micro device having a device substrate, a function element provided on a surface of the device substrate and having an oscillator or a movable part, and first lands provided on the surface of the device substrate by being arranged on an outer circumference portion of the function element;
a circuit board having second lands formed to correspond to the first lands and bumps provided to the second lands thereon the micro device is mounted from the first land formation surface side so that the bumps and the first lands are electrically connected;
a sealing resin layer formed to go round the outer circumference portion of the function element to fix connection portions of the bumps and the first lands and to seal a clearance between the device substrate and the circuit board;
wherein a cavity portion is formed between the function element and the circuit board.

9. A semiconductor device as set forth in claim 8,
wherein the cavity portion configured by inner wall surfaces of the device substrate, the function element, the circuit board and the sealing resin layer is kept to be vacuum, decompressed, a reducing atmosphere or an inert gas atmosphere.

10. A semiconductor device as set forth in claim 8,
wherein solder ball bumps for circuit board is formed on the other surface of the surface mounted with the micro device of the circuit board.

11. A semiconductor device as set forth in claim 8,
wherein
in the micro device, a cap is bonded on the device substrate to form the cavity portion to protect the function element, and
the sealing resin layer is formed to go round an outer circumference portion of the function element.

12. A semiconductor device as set forth in claim 11,
wherein
the circuit board is formed with a recessed portion corresponding to the cap, and
the micro device is mounted on the circuit board so that the cap is inserted to the recessed portion.

13. A method of producing a semiconductor device including mounting a micro device having a device substrate, a function element provided to a surface of the device substrate and having an oscillator or a movable part, first lands provided to the surface of the device substrate by being arranged on an outer circumference portion of the function element, and bumps provided to the first lands to a circuit board having second lands formed to correspond to the bumps, the method comprising the steps of:
forming an uncured sealing resin layer on the second lands so as to go round the outer circumference portion of the function element by including a second land formation region of the circuit board;
mounting the micro device to the circuit board from the bump formation surface side so that the bumps penetrate the sealing resin layer to contact and electrically connect to the second lands and the sealing resin layer seals a clearance between the device substrate and the circuit board; and
curing the sealing resin layer to fix connection portions of the bumps and the second lands.

14. A method of producing a semiconductor device as set forth in claim 13, wherein the step of mounting the micro device to the circuit board is performed under vacuum, decompressed, a reducing atmosphere or an inert gas atmosphere so that the cavity portion configured by inner wall surfaces of the device substrate, the function element, the circuit board and the sealing resin layer is kept to be vacuum, decompressed, a reducing atmosphere or an inert gas atmosphere.

15. A method of producing a semiconductor device as set forth in claim 13, further comprising a step of flattening a formation surface of the second lands of the circuit board before the step of forming the uncured sealing resin layer on the second lands.

16. A method of producing a semiconductor device as set forth in claim 13, further comprising a step of flattening a formation surface of the second lands of the circuit board before the step of forming the uncured sealing resin layer on the second lands so that a level difference between the second lands and a part excepting the second lands becomes 10% or less of a film thickness of a sealing resin layer.

17. A method of producing a semiconductor device as set forth in claim 13, further comprising a step of forming solder ball bumps for circuit board on the other surface of the surface mounted with the micro device of the circuit board.

18. A method of producing a semiconductor device including mounting a micro device having a device substrate, a function element provided to a surface of the device substrate and having an oscillator or a movable part, and first lands provided to the surface of the device substrate by being arranged on an outer circumference portion of the function element to a circuit board having second lands formed to correspond to the first lands and bumps provided to the second lands, the method comprising the steps of:
forming an uncured sealing resin layer on the first lands so as to go round the outer circumference portion of the function element by including a first land formation region of the device substrate;
mounting the micro device on the circuit board from the first land formation surface side so that the bumps penetrate the sealing resin layer to contact and electrically connect to the first lands and the sealing resin layer seals a clearance between the device substrate and the circuit board; and
curing the sealing resin layer to fix connection portions of the bumps and the first lands.

19. A method of producing a semiconductor device as set forth in claim 18, wherein the step of mounting the micro device to the circuit board is performed under vacuum, decompressed, a reducing atmosphere or an inert gas atmosphere so that the cavity portion configured by inner wall surfaces of the device substrate, the function element, the circuit board and the sealing resin layer is kept to be vacuum, decompressed, a reducing atmosphere or an inert gas atmosphere.

20. A method of producing a semiconductor device as set forth in claim 18, further comprising a step of forming solder ball bumps for circuit board on the other surface of the surface mounted with the micro device of the circuit board.
